# EUROPEAN PATENT APPLICATION

(11) **EP 4 560 300 A1**
(43) Date of publication of application: **28.05.2025**
(21) Application number: 24214732.0
(22) Date of filing: 22.11.2024
(51) Int. Cl.: G01N 25/18

(54) **THERMAL TESTING TOOL**

(30) Priority: 27.11.2023 TW 112145846
(71) Applicant: Cooler Master Co., Ltd., Taipei City 114065 (TW)
(72) Inventor: PENG, CHENG-SHU, Taipei City (TW); KUO, SY-CHI, Taipei City (TW); YE, RUI-QI, Taipei City (TW)
(74) Representative: Grünecker Patent- und Rechtsanwälte PartG mbB

(57) **Abstract**

A thermal testing tool comprises a base, a back plate, a heating assembly and a first sealing member. The back plate is arranged on the base and, together with the base, encloses a first accommodating recess and a second accommodating recess. The second accommodating recess is located at a periphery of the first accommodating recess. The heating assembly comprises a heating sheet. At least a portion of the heating sheet is located in the first accommodating recess. The first sealing member is arranged in the second accommodating recess and located at a periphery of at least a portion of the heating sheet.

## Description

### TECHNICAL FIELD

The present disclosure relates to a thermal testing tool, in particular a thermal testing tool having a polymer sealing member.

### BACKGROUND OF THE DISCLOSURE

With the rapid development of science and technology, the computing performance of various kinds of electronic components has improved considerably, with large amounts of heat being produced at the same time. When the heat produced by an electronic component during operation is too high, this is likely to cause damage to the electronic component, thus affecting the reliability of the electronic component.

During research and development of a computer system, research and development personnel need to test various function parameters of the computer system with a thermal testing tool to verify the reliability of the system. Thermal testing tools can be used in a variety of testing environments. As an example, a thermal testing tool can perform thermal testing in an immersion cooling system, such that the thermal testing tool is immersed in coolant. However, ingress of coolant into the immersion cooling system will reduce the operating performance of a heating assembly of the thermal testing tool, and may even reduce the service life of the heating assembly. Thus, the issue of how to avoid reduced operating performance and service life of a heating assembly due to ingress of coolant is a problem in need of a solution by research and development personnel.

### SUMMARY OF THE DISCLOSURE

The invention is as defined in the appended claims.

Exemplary embodiments of the present disclosure provide a thermal testing tool to facilitate avoidance of reduced operating performance, and avoidance of reduced service life, of a heating assembly due to the ingress of coolant.

Exemplary embodiment of the present disclosure provide a thermal testing tool comprising a base, a back plate, a heating assembly and a first sealing member. The back plate can be arranged on the base and, together with the base, can enclose a first accommodating recess and a second accommodating recess. The second accommodating recess can be located at a periphery of the first accommodating recess. The heating assembly comprises a heating sheet. At least a portion of the heating sheet is located in the first accommodating recess. The first sealing member is arranged in the second accommodating recess and located at a periphery of at least a portion of the heating sheet.

According to exemplary implementations of a thermal testing tool according to an exemplary embodiment, since the first sealing member and the second sealing member can be arranged in the second accommodating recess and the third accommodating recess respectively, the sealing effect between the base and the back plate can, but is not required to, be improved to help facilitate prevention of ingress of coolant of the immersion cooling system into the heating sheet located in the first accommodating recess when the thermal testing tool is immersed in coolant, and, for example and without limitation, help facilitate prevention of a consequent reduction in the operating performance and service life of the heating sheet.

The description of the content of the present disclosure above and the description of exemplary embodiments below are intended to demonstrate and explain the principle of the present disclosure, and can facilitate further understanding of the appended claims of the present disclosure.

### BRIEF DESCRIPTION OF THE DRAWINGS

A more complete appreciation of the present disclosure and many of the attendant advantages thereof will be readily obtained as the same becomes better understood by reference to the following detailed description when considered in connection with the accompanying drawings, wherein:
Fig. 1 is a 3D schematic drawing of a thermal testing tool according to a first embodiment of the present disclosure.
Fig. 2 is an exploded schematic drawing of the thermal testing tool in Fig. 1.
Fig. 3 is a sectional schematic drawing of the thermal testing tool in Fig. 1.
Fig. 4 is a planar schematic drawing of the base of the thermal testing tool in Fig. 1.
Fig. 5 is an exploded schematic drawing of a thermal testing tool according to a second embodiment of the present disclosure.
Fig. 6 is a sectional schematic drawing of the thermal testing tool in Fig. 5.
Fig. 7 is an exploded schematic drawing of a thermal testing tool according to a third embodiment of the present disclosure.
Fig. 8 is a sectional schematic drawing of the thermal testing tool in Fig. 7.

### DETAILED DESCRIPTION OF EXEMPLARY EMBODIMENTS

The matters exemplified in this description are provided to assist in a comprehensive understanding of exemplary embodiments of the disclosure. Accordingly, those of ordinary skill in the art will recognize that various changes and modifications of the embodiments described herein can be made without departing from the scope and spirit of the described disclosure. Also, descriptions of well-known functions and constructions are omitted for clarity and conciseness.

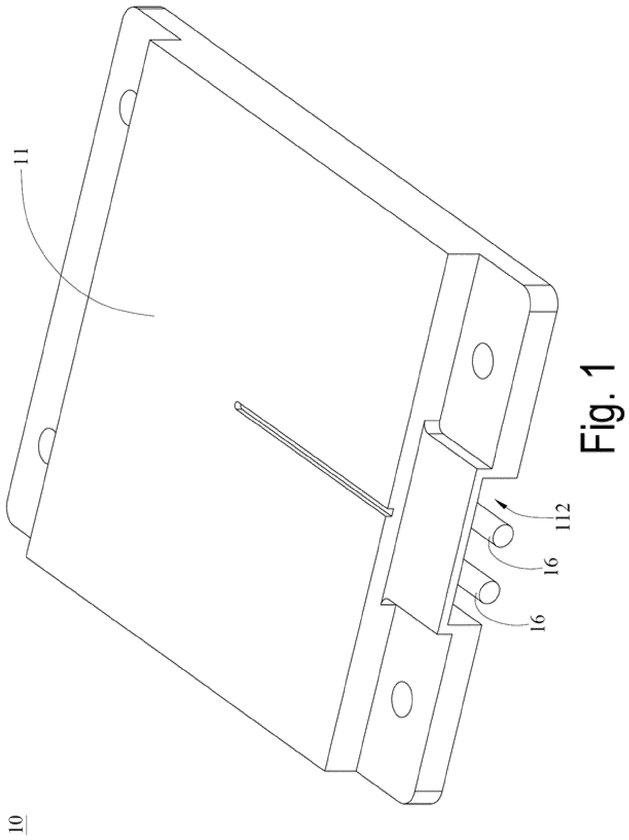

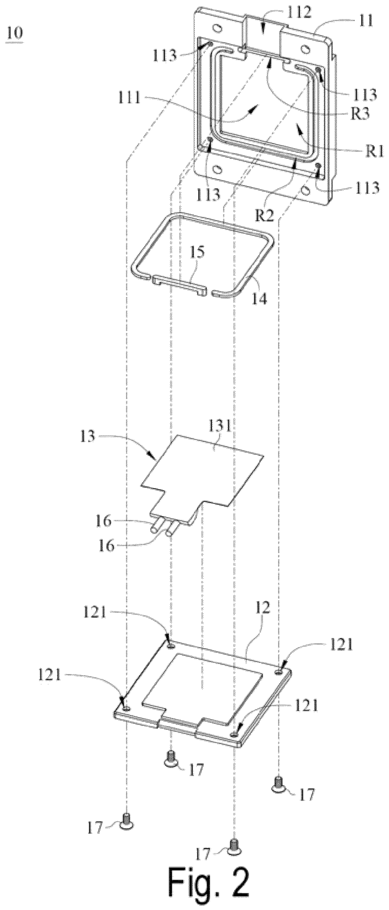

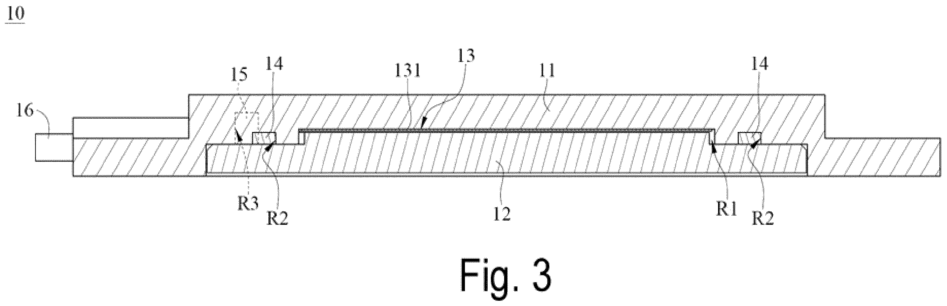

Referring to Figs. 1 - 3, Fig. 1 is a 3D schematic drawing of a thermal testing tool according to a first exemplary embodiment of the present disclosure, Fig. 2 is an exploded schematic drawing of the thermal testing tool in Fig. 1, and Fig. 3 is a sectional schematic drawing of the thermal testing tool in Fig. 1.

According to exemplary implementations, a thermal testing tool 10 of disclosed exemplary embodiment can for example be used in an immersion cooling system (not shown) and can be configured to be immersed in a coolant (not shown). The thermal testing tool 10 can, for example, comprise a base 11, a back plate 12, a heating assembly 13, a first sealing member 14 and a second sealing member 15. The back plate 12 can be arranged on the base 11 and, together with the base 11, can enclose a first accommodating recess R1, a second accommodating recess R2 and a third accommodating recess R3.

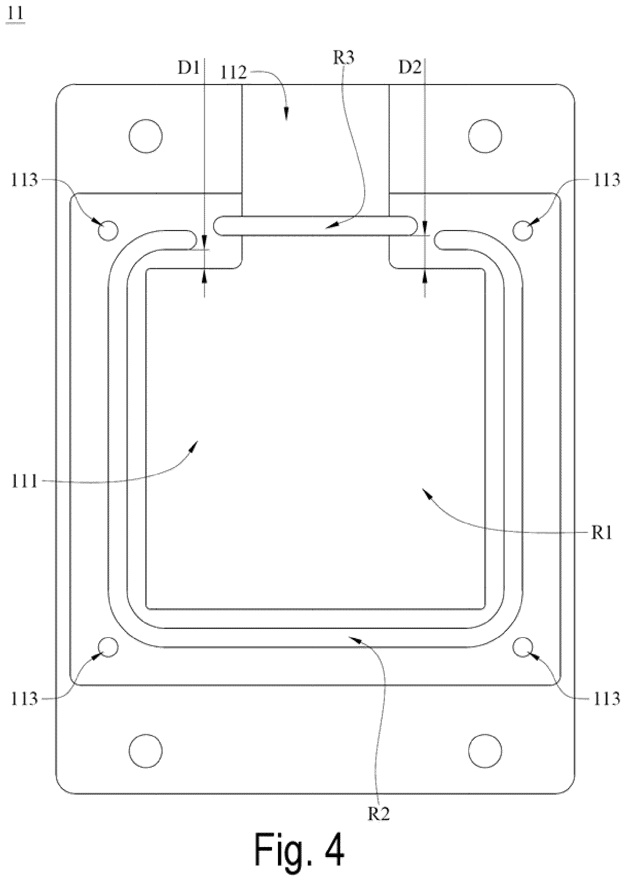

Referring to Fig. 4, which is a planar schematic drawing of the base of the thermal testing tool in Fig. 1, according to exemplary implementations, the base 11 can comprise an inner surface 111 facing toward the back plate 12. The first accommodating recess R1, the second accommodating recess R2 and the third accommodating recess R3 can be configured or located at the inner surface 111 and can be sunk inward. The base 11 can comprise a channel 112. The channel 112 can be configured to be in communication with the first accommodating recess R1. The second accommodating recess R2 can be configured or located at the periphery of the first accommodating recess R1 and separated from the first accommodating recess R1 by a distance D1. The third accommodating recess R3 can be located at one side of the first accommodating recess R1 and can be adjacent to the second accommodating recess R2. According to further exemplary implementations, the third accommodating recess R3 can be located at the channel 112 and separated from the first accommodating recess R1 by a distance D2. The distance D1 between the first accommodating recess R1 and the second accommodating recess R2 can, for example, be less than the distance D2 between the first accommodating recess R1 and the third accommodating recess R3.

According to yet other exemplary implementations, the heating assembly 13 can comprise a heating sheet 131. A portion of the heating sheet 131 can be configured or located in the first accommodating recess R1, and another portion of the heating sheet 131 can be configured or located in the channel 112. The first sealing member 14 can, for example, be applied to the second accommodating recess R2 and can be configured or located at the periphery of at least a portion of the heating sheet 131. The second sealing member 15 can, for example, be applied to the third accommodating recess R3. The first sealing member 14 and the second sealing member 15 can, for example and without limitation, be formed of a high polymer of a fluorocarbon polymer, acrylic resin, epoxy resin, polyethylene, polypropylene, polycarbonate or a combination thereof.

In exemplary implementations of exemplary embodiments of the present disclosure, the term "applied" can mean that reactants are packed in advance into the accommodating recesses R2, R3, for example and without limitation by means of a scraper, a steel plate, or glue spot coating. After application and assembly of the heating assembly 13, the reactants can react in the accommodating recesses R2, R3, thereby forming, for example the high polymer, sealing members 14, 15.

According to exemplary implementations of exemplary embodiments of the present disclosure, the sealing effect between the base 11 and the back plate 12 can be, but is not required to be, improved by providing the first sealing member 14 in the second accommodating recess R2 and the second sealing member 15 in the third accommodating recess R3; this can facilitate prevention of ingress of coolant of the immersion cooling system into the heating sheet 131 located in the first accommodating recess R1 when the thermal testing tool 10 is immersed in coolant, and can facilitate prevention of a consequent reduction in the operating performance and service life of the heating sheet 131.

In yet other exemplary implementations, the thermal testing tool 10 may further comprise two cables 16. The two cables 16 can be connected to the heating sheet 131 at the channel 112 and can be electrically connected to an external power supply (not shown) so as to transmit power to the heating sheet 131 via the two cables 16.

In still further exemplary implementations, the thermal testing tool 10 may further comprise multiple fasteners 17. The fasteners 17 can be screws for example. The back plate 12 can comprise multiple first fastening holes 121, and the base 11 can comprise multiple second fastening holes 113. The first fastening holes 121 and the second fastening holes 113 can be threaded holes for example. The fasteners 17 can pass through the first fastening holes 121 and the second fastening holes 113 to fix, or otherwise secure or engage, the back plate 12 to the base 11.

In still further exemplary implementations, the back plate 12 can be fitted tightly to the base 11 through the fastening of the fasteners 17. For example and without limitation, the back plate 12 and the base 11 may then apply pressure to the first sealing member 14 and the second sealing member 15 to more tightly fit the first sealing member 14 and the second sealing member 15 to the second accommodating recess R2 and the third accommodating recess R3 respectively, thus, for example and without limitation, further improving the sealing effect between the base 11 and the back plate 12.

In yet other further exemplary implementations, the thermal testing tool 10 can comprise the first sealing member 14 and the second sealing member 15, and the back plate 12 and base 11 together can enclose the second accommodating recess R2 and the third accommodating recess R3, so that, for example and without limitation, the first sealing member 14 and the second sealing member 15 can be arranged in the second accommodating recess R2 and the third accommodating recess R3 respectively. In yet other exemplary implementations of exemplary embodiments of the present disclosure, it is also possible for the thermal testing tool to only comprise the first sealing member, and it is also possible for the back plate and the base to together enclose the second accommodating recess alone, so that the first sealing member can be arranged in the second accommodating recess.

According to further exemplary implementations, the back plate 12 can be fixed to the base 11 by means of the multiple fasteners 17, in the form of fasteners, such as for example and without limitation screws, passing through the first fastening holes 121 and the second fastening holes 113. In yet other exemplary implementations of disclosed embodiments, the back plate could be fixed to the base by means of multiple fasteners in another form passing through the first fastening holes and the second fastening holes. The fasteners in another form can be, for example and without limitation, in a form of clamps. When the fasteners are in the form of for example clamps, the first fastening holes and the second fastening holes could be omitted, and the back plate and base could be clamped by the fasteners in the form of clamps, for example to fix the back plate to the base.

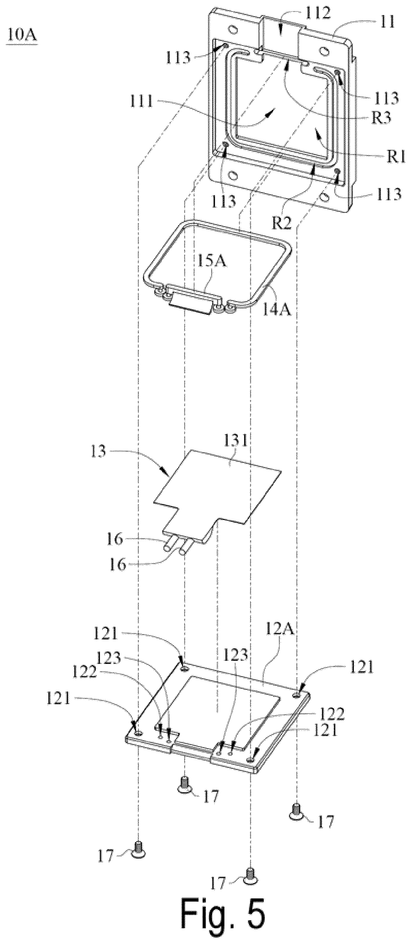

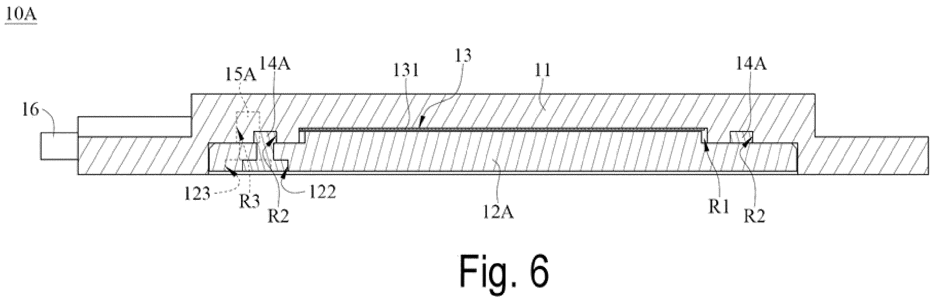

According to still further exemplary implementations, of the disclosed embodiments, the first sealing member 14 and the second sealing member 15 can, for example and without limitation, be applied to the second accommodating recess R2 and the third accommodating recess R3 respectively. Other exemplary implementations of further exemplary embodiments can be described with reference to Figs. 5 and 6, where Fig. 5 is an exploded schematic drawing of a thermal testing tool according to a second embodiment of the present disclosure, and Fig. 6 is a sectional schematic drawing of the thermal testing tool in Fig. 5.

According to exemplary implementations, of the further disclosed exemplary embodiments, thermal testing tool 10A can be similar to the thermal a testing tool 10 according to the first exemplary embodiment, so the differences between the further exemplary embodiments and the first exemplary embodiment are explained below, but identical or similar features may not be described again for conciseness. In exemplary implementations of the further exemplary embodiments, the thermal testing tool 10A can comprise a base 11, a back plate 12A, a heating assembly 13, a first sealing member 14A and a second sealing member 15A. The back plate 12A can be arranged on the base 11 and, together with the base 11, can encloses a first accommodating recess R1, a second accommodating recess R2 and a third accommodating recess R3 which can be separate from one another.

In exemplary implementations, the back plate 12A can comprise multiple first injection holes 122 and multiple second injection holes 123. The first injection holes 122 can be in communication with the second accommodating recess R2, and the second injection holes 123 can be in communication with the third accommodating recess R3. The first sealing member 14A and the second sealing member 15A can be respectively injected into the second accommodating recess R2 and the third accommodating recess R3 via, for example, the first injection holes 122 and the second injection holes 123.

In further exemplary implementations, the thermal testing tool 10A can comprise the first sealing member 14A and the second sealing member 15A, the back plate 12A and the base 11 together can enclose the second accommodating recess R2 and the third accommodating recess R3, and the back plate 12A can comprise multiple first injection holes 122 and multiple second injection holes 123, so that the first sealing member 14A and the second sealing member 15A can, for example and without limitation, be respectively injected into the second accommodating recess R2 and the third accommodating recess R3 via the first injection holes 122 and the second injection holes 123. In other exemplary implementation of disclosed exemplary embodiments, it is also possible for the thermal testing tool to only comprise the first sealing member, it is also possible for the back plate and the base to together enclose the second accommodating recess alone, and it is also possible for the back plate to only have multiple first injection holes, so that the first sealing member can be injected into the second accommodating recess via, for example and without limitation, the first injection holes.

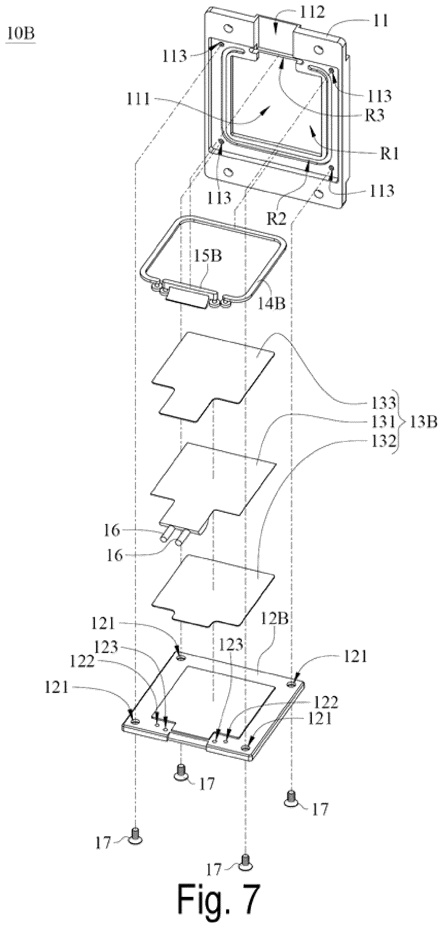

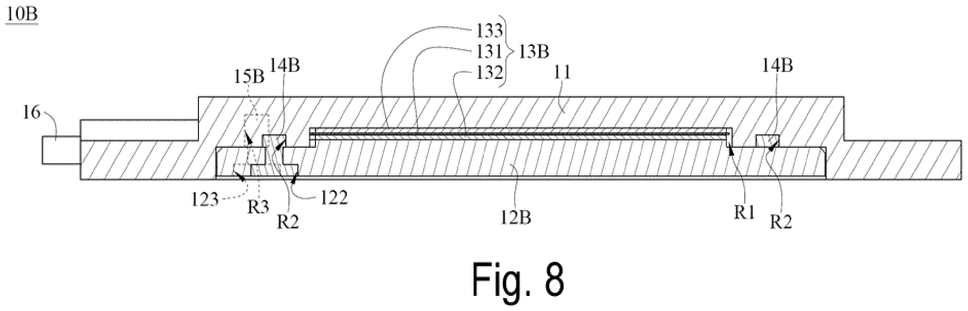

Referring to Figs. 7 and 8, Fig. 7 is an exploded schematic drawing of a thermal testing tool according to a third exemplary embodiment of the present disclosure, and Fig. 8 is a sectional schematic drawing of the thermal testing tool in Fig. 7.

According to exemplary implementations, the thermal testing tool 10B according to an exemplary third embodiment can be similar to the thermal testing tool 10 in the exemplary first embodiment, so the differences between exemplary third embodiment and the exemplary first embodiment are explained below, but identical or similar features may not be described again for conciseness. In exemplary implementations, the thermal testing tool 10B can comprises a base 11, a back plate 12B, a heating assembly 13B, a first sealing member 14B and a second sealing member 15B. The back plate 12B can be configured or arranged on the base 11 and, together with the base 11, can enclose a first accommodating recess R1, a second accommodating recess R2 and a third accommodating recess R3 which can be separate from one another.

According to exemplary implementations, the back plate 12B can comprise multiple first injection holes 122 and multiple second injection holes 123. The first injection holes 122 can be in communication with the second accommodating recess R2, and the second injection holes 123 can be in communication with the third accommodating recess R3. The first sealing member 14B and the second sealing member 15B can be respectively injected into the second accommodating recess R2 and the third accommodating recess R3 via, for example and without limitation, the first injection holes 122 and the second injection holes 123.

According to further exemplary implementations, the heating assembly 13B can comprise a heating sheet 131, a first electrical insulating sheet 132 and a second electrical insulating sheet 133. The first electrical insulating sheet 132 and the second electrical insulating sheet 133 can be thermally conductive. At least a portion of the first electrical insulating sheet 132 can be configured or located in the first accommodating recess R1 and stacked on the heating sheet 131. At least a portion of the second electrical insulating sheet 133 can be configured or located in the first accommodating recess R1 and stacked on the heating sheet 131, and the heating sheet 131 can be configured or located between the first electrical insulating sheet 132 and the second electrical insulating sheet 133, such that, for example, the heating sheet 131, after heating up, can transmit heat to the outside via the first electrical insulating sheet 132 and the second electrical insulating sheet 133. In yet further exemplary implementations, the first sealing member 14B can be located or configured at the periphery of at least a portion of the first electrical insulating sheet 132 and at least a portion of the second electrical insulating sheet 133. The stability of the heating assembly 13B during high-power use can, but is not required to, be improved by providing the first electrical insulating sheet 132 and the second electrical insulating sheet 133.

According to further exemplary implementations, the thermal testing tool 10B can comprise the first sealing member 14B and the second sealing member 15B, the back plate 12B and the base 11 together can enclose the second accommodating recess R2 and the third accommodating recess R3, and the back plate 12B can comprise multiple first injection holes 122 and multiple second injection holes 123, so that, for example, the first sealing member 14B and the second sealing member 15B can be respectively injected into the second accommodating recess R2 and the third accommodating recess R3 via, for example and without limitation, the first injection holes 122 and the second injection holes 123. In still further exemplary implementations of disclosed embodiments, it is also possible for the thermal testing tool to only comprise the first sealing member, it is also possible for the back plate and the base to together enclose the second accommodating recess alone, and it is also possible for the back plate to only have multiple first injection holes, so that the first sealing member can be injected into the second accommodating recess via, for example and without limitation, the first injection holes.

In further exemplary implementations of the disclosed embodiment, the heating assembly 13B can comprise one heating sheet 131 and two electrical insulating sheets 132, 133, the heating sheet 131B can, for example and without limitation, be configured or located between the two electrical insulating sheets 132, 133. In yet other exemplary implementations, it is also possible for the heating assembly to only comprise one heating sheet and one electrical insulating sheet, where the heating sheet can be located at one side of the electrical insulating sheet.

In the thermal testing tool according to exemplary implementations of the disclosed exemplary embodiments above, since the first sealing member and the second sealing member can be arranged in the second accommodating recess and the third accommodating recess respectively, the sealing effect between the base and the back plate can, but is not required to, be improved to facilitate prevention of ingress of coolant of the immersion cooling system into the heating sheet located in the first accommodating recess when the thermal testing tool is immersed in coolant, and to facilitate prevention of a consequent reduction in the operating performance and service life of the heating sheet.

The above-presented description and figures are intended by way of example only and are not intended to limit the illustrative embodiments in any way except as set forth in the appended claims. It is particularly noted that various technical aspects of the various elements of the various exemplary embodiments that have been described above can be combined in numerous other ways, all of which are considered to be within the scope of the disclosure.

Accordingly, although the exemplary embodiments have been disclosed for illustrative purposes, those skilled in the art will appreciate that various modifications, additions, and substitutions are possible. Therefore, the disclosure is not limited to the above-described embodiments, but may be modified within the scope of appended claims, along with their full scope of equivalents..

The terms and corresponding labels referenced in the disclosure are listed below for convenience. As would be readily appreciated by skilled artisans in the relevant art, while these and other descriptive terms are used throughout this specification to facilitate understanding, it is not intended to limit any components that can be used in combinations or individually to implement various aspects of the embodiments of the present disclosure.
10, 10A, 10B: thermal testing tool
11: base
111: inner surface
112: channel
113: second fastening hole
12, 12A, 12B: back plate
121: first fastening hole
122: first injection hole
123: second injection hole
13, 13B: heating assembly
131: heating sheet
132: first electrical insulating sheet
133: second electrical insulating sheet
14, 14A, 14B: first sealing member
15, 15A, 15B: second sealing member
16: cable
17: fastener
D1, D2: distance
R1: first accommodating recess
R2: second accommodating recess
R3: third accommodating recess

## Claims

1. A thermal testing tool (10, 10A, 10B), comprising:
a base (11);
a back plate (12, 12A, 12B), arranged on the base (11) and, together with the base (11), enclosing a first accommodating recess (R1) and a second accommodating recess (R2), the second accommodating recess (R2) configured at a periphery of the first accommodating recess (R1);
a heating assembly (13, 13B) comprising a heating sheet (131), at least a portion of the heating sheet (131) configured in the first accommodating recess (R1); and
a first sealing member (14, 14A, 14B) configured in the second accommodating recess (R2) and at a periphery of at least a portion of the heating sheet (131).

2. The thermal testing tool (10, 10A, 10B) as claimed in claim 1, wherein the first accommodating recess (R1) and the second accommodating recess (R2) are separated by a first distance (D1).

3. The thermal testing tool (10A, 10B) as claimed in claim 1 or 2, wherein the back plate (12A, 12B) comprises at least one first injection hole (122) in communication with the second accommodating recess (R2).

4. The thermal testing tool (10, 10A, 10B) as claimed in one of claims 1 to 3, further comprising:
a second sealing member (15, 15A, 15B); and
a third accommodating recess (R3)
wherein
the back plate (12, 12A, 12B) and the base (11) enclose the third accommodating recess (R3),
the third accommodating recess (R3) is configured at one side of the first accommodating recess (R1) and adjacent to the second accommodating recess (R2), and
the second sealing member (15, 15A, 15B) is configured in the third accommodating recess (R3).

5. The thermal testing tool (10, 10A, 10B) as claimed in claim 4, wherein
the first accommodating recess (R1) and the third accommodating recess (R3) are separated by a second distance (D2), and
the first distance (D1) between the first accommodating recess (R1) and the second accommodating recess (R2) is less than the second distance (D2) between the first accommodating recess and the third accommodating recess (R3).

6. The thermal testing tool (10A, 10B) as claimed in claim 4 or 5, wherein the back plate (12A, 12B) comprises at least one second injection hole (123) in communication with the third accommodating recess (R3).

7. The thermal testing tool (10, 10A, 10B) as claimed in one of claims 4 to 6, further comprising:
at least one cable (16);
a channel (112);
wherein
the base (11) comprises the channel (112) in communication with the first accommodating recess (R1),
a portion of the heating sheet (131) is configured in the first accommodating recess (R1),
another portion of the heating sheet (131) is configured in the channel (112),
the at least one cable (16) is connected to the heating sheet (131) at the channel (112), and
the third accommodating recess (R3) is configured at the channel (112).

8. The thermal testing tool (10, 10A, 10B) as claimed in one of claims 4 to 7, wherein
the base (11) comprises an inner surface (111) facing toward the back plate (12, 12A, 12B), and
the first accommodating recess (R1), the second accommodating recess (R2) and the third accommodating recess (R3) are configured at the inner surface (111) and are sunk inward.

9. The thermal testing tool (10B) as claimed in one of claims 4 to 8, wherein
the heating assembly (13B) comprises a first electrical insulating sheet (132),
at least a portion of the first electrical insulating sheet (132) is configured in the first accommodating recess (R1) and stacked on the heating sheet (131), and
the first sealing member (14B) is configured at a periphery of at least a portion of the first electrical insulating sheet (132).

10. The thermal testing tool (10B) as claimed in claim 9, wherein
the heating assembly (13B) comprises a second electrical insulating sheet (133),
at least a portion of the second electrical insulating sheet (133) is configured in the first accommodating recess (R1) and stacked on the heating sheet (131),
the heating sheet (131) is configured between the first electrical insulating sheet (132) and the second electrical insulating sheet (133), and
the first sealing member (14B) is configured at a periphery of at least a portion of the second electrical insulating sheet (133).

11. The thermal testing tool (10, 10A, 10B) as claimed in one of claims 4 to 10, wherein the first sealing member (14, 14A, 14B) and the second sealing member (15, 15A, 15B) are formed of a fluorocarbon polymer, acrylic resin, epoxy resin, polyethylene, polypropylene, polycarbonate or a combination thereof.

12. The thermal testing tool (10, 10A, 10B) as claimed in one of claims 1 to 11, further comprising:
at least one fastener (17);
at least one first fastening hole (121); and
at least one second fastening hole (113),
wherein
the back plate (12, 12A, 12B) comprises the at least one first fastening hole (121),
the base (11) comprises the at least one second fastening hole (113), and
the at least one fastener (17) passes through the at least one first fastening hole (121) and the at least one second fastening hole (113) to fix the back plate (12, 12A, 12B) to the base (11).
